Europäisches Patentamt

European Patent Office

Office européen des brevets

(11) Publication number: 0 516 908 A2

# EUROPEAN PATENT APPLICATION

(21) Application number: 91312111.7

(22) Date of filing: 31.12.91

(51) Int. Cl.⁵: H03K 3/354, H03B 5/24

(30) Priority: 07.06.91 JP 163933/91

(43) Date of publication of application:
09.12.92 Bulletin 92/50

(84) Designated Contracting States:
DE FR GB

(71) Applicant: MITSUBISHI DENKI KABUSHIKI
KAISHA
2-3, Marunouchi 2-chome Chiyoda-ku
Tokyo(JP)

(72) Inventor: Katoh, Takayuki, c/o Mitsub. Denki K.
K., Optel.
and Microwave Devices R & D Lab., No. 1,
Mizuhara
4-chome, Itami-shi, Hyogo-ken(JP)

(74) Representative: Beresford, Keith Denis Lewis
et al
BERESFORD & Co. 2-5 Warwick Court High
Holborn
London WC1R 5DJ(GB)

(54) Variable frequency oscillator.

(57) A variable frequency oscillator comprises a voltage controlled oscillator including a variable capacitance diode, a control voltage applied to the diode, by which the output frequency of the voltage controlled oscillator is controlled, a control voltage power supply generating the control voltage, and an impedance conversion means for decreasing the output impedance of the control voltage power supply, provided between the voltage controlled oscillator and the control voltage power supply. Therefore, a current having high current driving ability is applied to the voltage controlled oscillator, whereby the self-detecting voltage can be suppressed while the oscillation output of the circuit is increased. As a result, a variable frequency oscillator having an improved linearity of oscillation frequency can be obtained.

F I G. 1

## FIELD OF THE INVENTION

The present invention relates to an improvement of a semiconductor integrated circuit (variable frequency oscillator) which operates at a high frequency band, for example several tens MHz.

## PRIOR ART

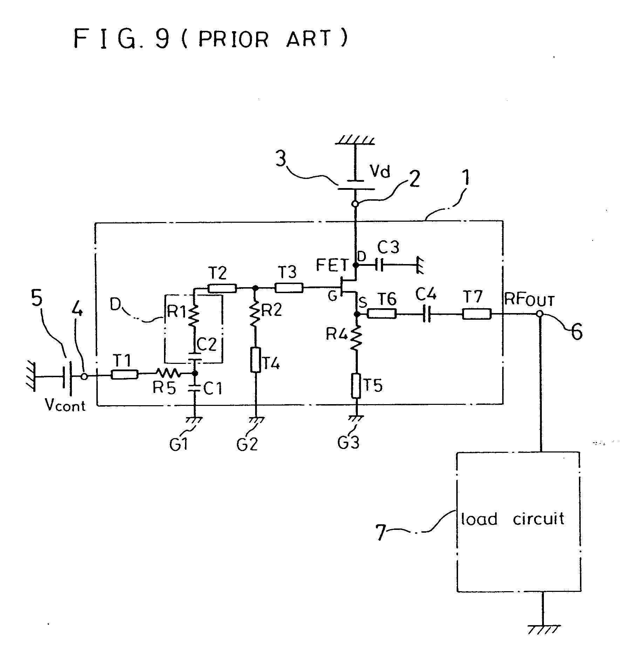

Figure 9 is a circuit diagram showing a prior art variable frequency oscillator utilizing a voltage controlled oscillator and peripheral circuits thereof. In figure 9, a voltage controlled oscillator (hereinafter referred to as VCO) 1 has a varactor diode (variable reactance diode) D comprising a resistor R1 and a capacitor C2, and an FET whose gate is connected to one end of the diode D, as its fundamental constituents.

A drain of this FET serves as a drain terminal 2 of the VCO 1 and a driving voltage (hereinafter referred to as $V_d$) is applied thereto from an external drain power supply 3 while a source of the FET is connected to an RF output terminal 6 via a capacitor C4. The other end of the diode D is connected to a ground G1 via a capacitor C1 and a control voltage (hereinafter referred to as $V_{cont}$) is applied thereto from an external control power supply (control voltage power supply part) 5 via a control terminal 4 and a resistor R5 of the VCO 1. A load circuit 7 is connected to the RF output terminal 6. Reference numerals T1 to T7 designate transmission lines for connecting these elements. Reference numerals R2 and R4 are resistors for obtaining a desired impedance in the VCO 1. These resistors R2 and R4 are connected to the grounds G2 and G3 via the transmission lines T4 and T5, respectively.

A description is given of the operation hereinafter. In the variable frequency oscillator of common drain/source output type in which the drain of the FET of the VCO 1 is grounded while the source thereof becomes an oscillation output, in order to drive the FET of VCO 1 which performs amplification, a positive or negative control voltage $V_{cont}$ (usually 0 to 3V) is directly applied to the control terminal 4 while a positive driving voltage $V_d$ (usually 3 to 5V) is applied to the drain terminal 2 from the drain power supply 3, whereby a microwave corresponding to the control voltage $V_{cont}$ is applied to the load circuit 7 from the RF output terminal 6.

More specifically, a voltage applied to the gate of the FET is controlled by that a reverse bias current is applied to the diode D by the control voltage $V_{cont}$ to vary the capacitance of the diode D, whereby the amplification characteristic of the FET is varied and a microwave which is amplified to a desired value is output to the load circuit 7.

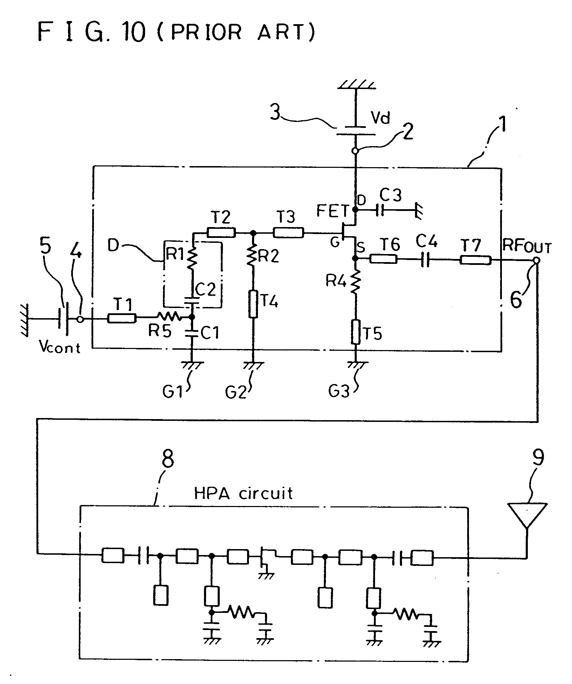

Figure 10 shows a transmission circuit comprising a high output amplifier 8 and an antenna 9, as an example of the load circuit 7.

In the prior art variable frequency oscillator constituted as described above, even when an increase in the oscillation frequency is attempted, a microwave corresponding to the control voltage supplied from the control terminal 4 is not output, and the performance characteristic is lowered.

The reason is as follows. When the frequency of the microwave which is output while the oscillation output is increased exceeds a predetermined value, the varactor diode D included in the VCO 1 detects the microwave which is output from the RF terminal 6, and then a current due to the self-detecting voltage (usually 1 to 3V) flows from the ground G2 to the control terminal 4. Here, no current flows between the ground G1 and the control terminal 4 because of the existence of capacitor C1. When such a self-detecting voltage is generated, if the current driving ability of the control power supply 5 is low, the potential of the control terminal 4 cannot be controlled any more. Then, a microwave due to the self-detecting voltage is output regardless of the potential of the control terminal 4.

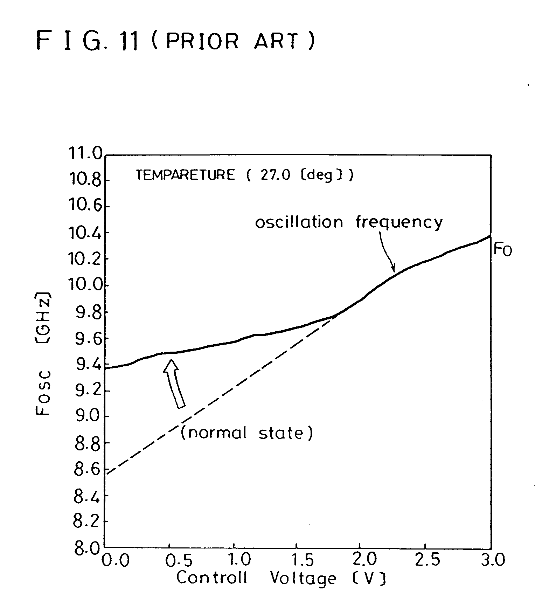

This will be explained in detail with reference to figure 11. When the circuit output is increased and a self-detecting voltage is generated by the reason as described above, an output of approximately 9.4 GHz appears at the RF output terminal 6 disregarding that the potential of the control terminal 4 is 0V, and the linearity of the oscillation frequency $F_0$ is damaged in a region where the voltage of the control power supply is below approximately 1.8 V. In a case where a frequency synthesizer or the like is used as a load circuit, oscillation cannot be obtained at the frequency below a predetermined value, thereby reducing the frequency band which can be utilized.

Meanwhile, Japanese Laid-open Patent Application No. 2-256311 discloses a VCO circuit frequency-oscillating in accordance with an output current of a current mirror circuit, in which a fixed voltage circuit for driving the current mirror circuit is connected to the current mirror circuit and the output current of the current mirror circuit is controlled by a source follower circuit. This current mirror circuit converts voltage into current and supplies the current to the VCO circuit, and the current mirror circuit itself has a diode junction. Therefore, this prior art VCO circuit cannot solve the above described problems.

## SUMMARY OF THE INVENTION

The present invention is directed to solving the above-described problems and has for its object to provide a variable frequency oscillator that can improve the linearity of oscillation frequency with no influence of the self-detecting voltage even when an increase in the oscillation output is attempted.

Other objects and advantages of the present invention will become apparent from the detailed description given hereinafter; it should be understood, however, that the detailed description and specific embodiment are given by way of illustration only, since various changes and modifications within the spirit and the scope of the invention will become apparent to those skilled in the art from this detailed description.

In accordance with a variable frequency oscillator of the present invention, an impedance conversion means for lowering an output impedance of a control voltage power supply is provided between a voltage controlled oscillator and the control voltage power supply. Therefore, a current having high current driving ability is applied to the voltage controlled oscillator and the self-detecting voltage can be effective suppressed. As a result, the oscillation output can be largely increased while the linearity of the oscillation frequency is improved.

## BRIEF DESCRIPTION OF THE DRAWINGS

Figure 1 is a circuit diagram showing a variable frequency oscillator in accordance with a first embodiment of the present invention;
Figure 2 is a graph showing an input voltage vs. output voltage characteristic of a source follower circuit of the variable frequency oscillator in accordance with the first embodiment of the present invention;

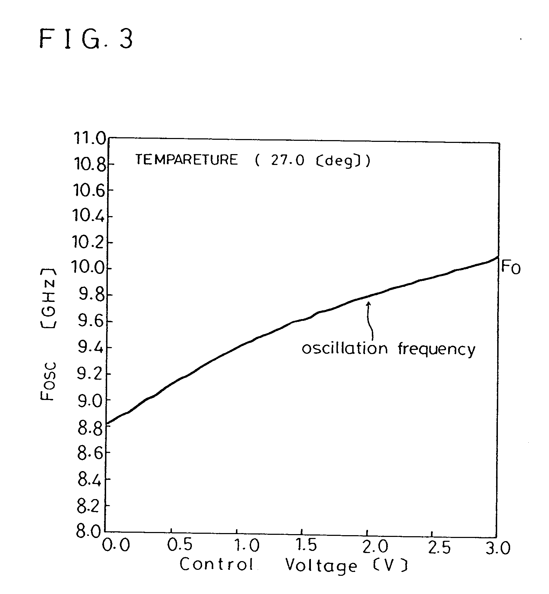

Figure 3 is a graph showing a control voltage $V_{cont}$ vs. oscillation frequency characteristic of the variable frequency oscillator in accordance with the first embodiment of the present invention;
Figure 4 is a circuit diagram showing a variable frequency oscillator in accordance with a second embodiment of the present invention;
Figure 5 is a plan view showing an alternative of the source follower circuit of the variable frequency oscillator of figure 1;
Figure 6 is a plan view showing a variable frequency oscillator in accordance with a third embodiment of the present invention;
Figure 7 is a plan view showing a variable frequency oscillator in accordance with a fourth embodiment of the present invention;
Figure 8 is a plan view showing a variable frequency oscillator in accordance with a fifth embodiment of the present invention;
Figure 9 is a circuit diagram showing a variable frequency oscillator in accordance with the prior art;
Figure 10 is a circuit diagram showing an example of the prior art variable frequency oscillator in which a load circuit is constituted by a high output amplifier and an antenna; and
Figure 11 is a graph showing a control voltage $V_{cont}$ vs. oscillation frequency characteristic of the prior art variable frequency oscillator.

## DETAILED DESCRIPTION OF THE PREFERRED EMBODIMENTS

Embodiments of the present invention will be described in detail with reference to the drawings.

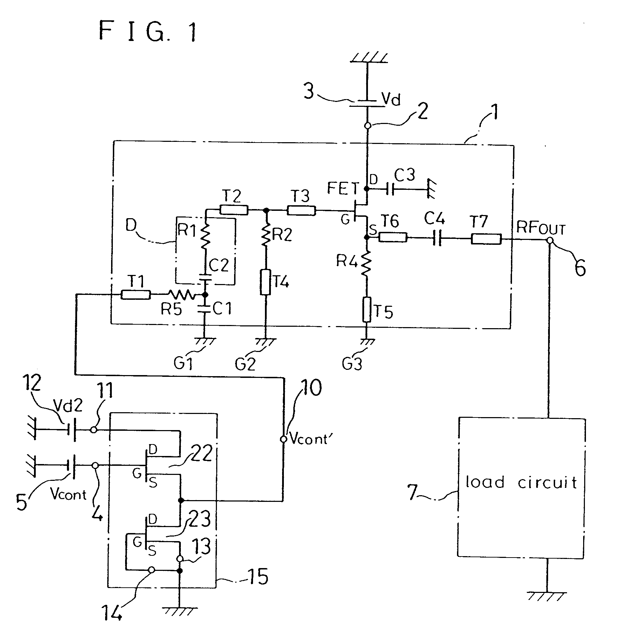

Figure 1 is a circuit diagram showing a variable frequency oscillator in accordance with a first embodiment of the present invention. In figure 1, the same reference numerals as those shown in figures 9 and 10 designate the same parts. A source follower circuit 15 is provided between the VCO 1 and the control power supply terminal 4. Reference numeral 10 designates an output terminal of the source follower circuit 15.

The source follower circuit 15 is constituted by two field effect transistors (hereinafter referred to as FETs) 22 and 23, each having a source and a drain connected in parallel. A junction point of the FETs 22 and 23 is connected to the output terminal 10 of the source follower circuit 15. In addition, the gate of the first FET 22 serves as the control terminal 4 of the VCO 1 and a control voltage $V_{cont}$ is supplied from the control power supply 5. A driving voltage $V_{d2}$ is applied to the drain of the first FET 22 from the drain power supply 12 via the drain terminal 11. The gate terminal 14 and source terminal 13 of the second FET 23 are connected with each other and are grounded.

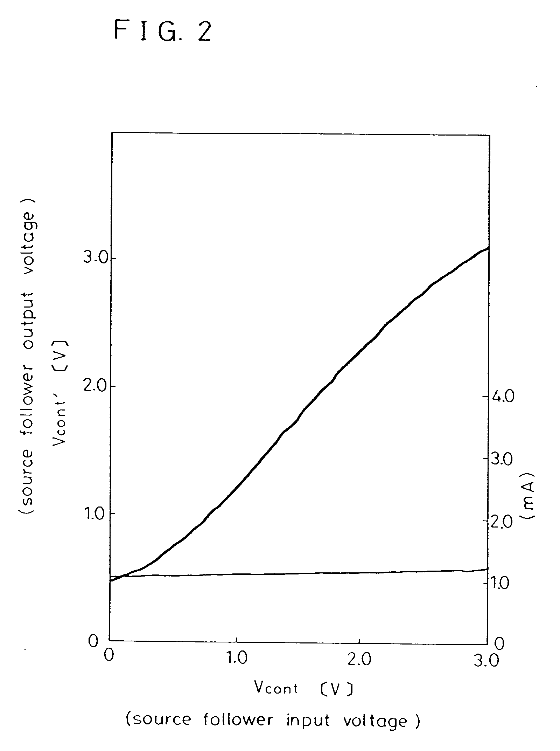

A description is given of the operation. Figure 2 is a graph showing the relation between the input voltage $V_{cont}$ and the voltage $V_{cont}$, of the output terminal 10 of the source follower circuit 15 when a driving voltage $V_{d2}$ (usually 3 to 5 V) for driving the first FET 22 is applied from the drain power supply 12 via the drain terminal 11. As is seen from figure 2, when the input voltage $V_{cont}$ varies from 0V to 3V, the output voltage $V_{cont}$, varies almost linearly from about 0.5V to about 3V. In addition, the consumption current of the whole circuit is increased a little because the source follower circuit is added (when $V_{cont}$ is 3V, about 1.2 mA).

Since this source follower circuit 15 uses the junction point of the drain terminal of second FET 23 and the source terminal of first FET 22 as its output terminal 10, the output impedance is as low as several $\Omega$, and the current driving ability can be enhanced by that the driving voltage $V_{d2}$ is controlled by varying the input voltage $V_{cont}$ to be output from the source follower circuit 15. Therefore, the self-detecting voltage of the diode D can be effectively suppressed by applying this high driving ability output to the VCO 1. As a result, an oscillation frequency having an improved linearity of the frequency whose signal is output from the RF electrode terminal 6, against the variation in the control voltage $V_{cont}$ is obtained.

In addition, since the source follower circuit 15 uses the gate terminal of first FET 22 as the input terminal of control power supply 5, the input impedance is as high as several KΩ or more and a current hardly flows while it is used. Accordingly, even when the control power supply has low current driving ability, the device can be operated.

In the first embodiment of the present invention, the source follower circuit 15 comprising two FETs and having a high input impedance and a low output impedance is provided between the control power supply 5 and the VCO 1, and the driving voltage $V_{d2}$ is controlled by the control voltage $V_{cont}$ and then it is applied to the VCO 1. Therefore, the current driving ability is enhanced and even when a self-detecting voltage is generated in the diode D, this self-detecting voltage is suppressed by releasing it from the source of second FET 23 to the ground, whereby a frequency output having linearity against the voltage of the control power supply 5 can be performed, resulting in a device having superior operation characteristics.

In addition, since the input impedance of the source follower circuit 15 is high, the self-detecting voltage from the diode D does not flow into the control terminal 4. Accordingly, even when the current driving ability of the control power supply 5 is low, the device can be operated.

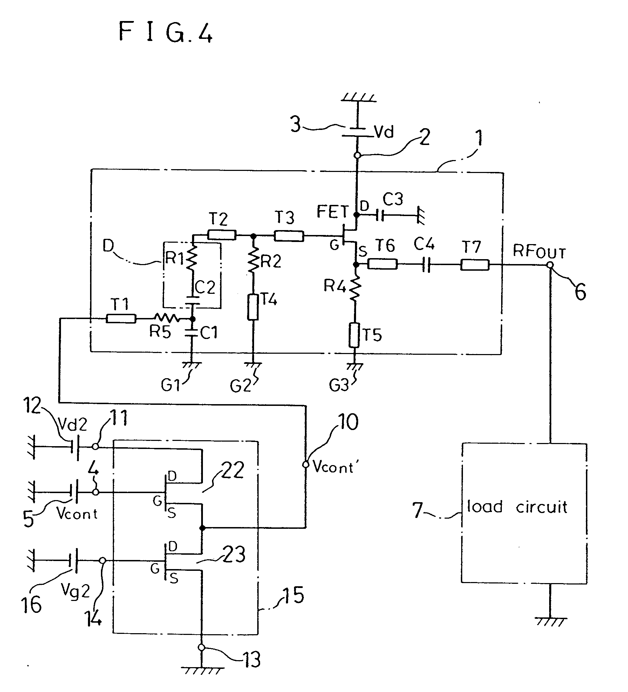

Figure 4 is a circuit diagram showing a variable frequency oscillator in accordance with a second embodiment of the present invention. In this second embodiment, the gate electrode 14 of the second FET 3 of the source follower circuit 15 is not connected to the source terminal 13 and a voltage (usually 0V to -0.5V) is applied to the gate electrode 14 using the gate power supply 16.

In the circuit constructed as described above, by controlling the gate power supply 16 of the second FET 3 of the source follower circuit 15, a portion of the drain voltage 12 which is applied to the FET 2 is prevented from flowing into the ground via the source terminal 13 of the FET 3, thereby suppressing an increase in consumption current caused by the addition of the source follower circuit 15 to the minimum.

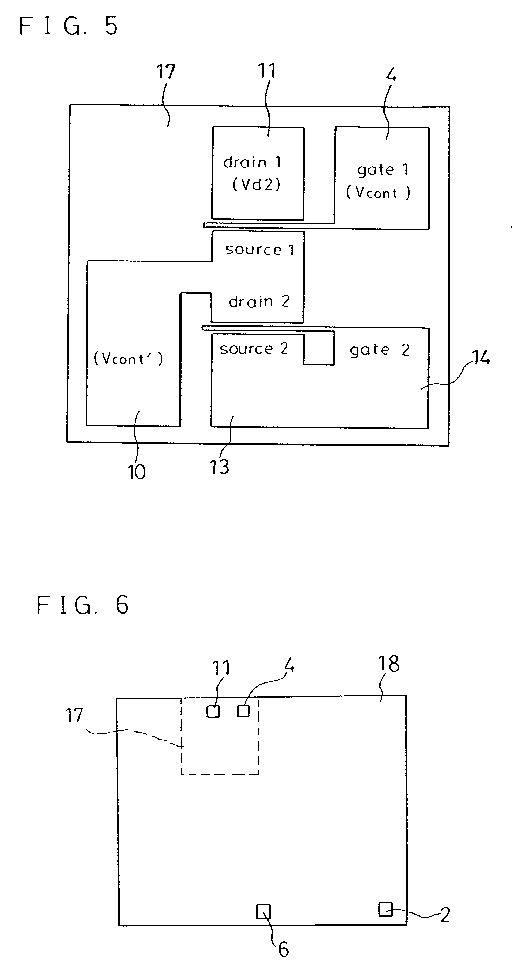

Figure 5 is a plan view showing a structure of a source follower circuit in a case where the source follower circuit 15 of figure 1 is monolithically formed. In figure 5, reference numeral 17 designates an MMIC (monolithic microwave integrated circuit) source follower circuit chip, in which a first and second FETs are formed. A driving voltage $V_{d2}$ is applied to the drain terminal 11 of the first FET while a control voltage $V_{cont}$ for VCO is applied to the gate terminal 4 of the first FET, and a voltage corresponding to thus applied voltages is output from the output terminal 10.

Figure 6 is a plan view showing a variable frequency oscillator including the source follower circuit of figure 5, in accordance with a third embodiment of the present invention. In figure 6, reference numeral 18 designates an MMIC voltage controlled oscillator chip. More specifically, the MMIC source follower circuit chip 17 shown in figure 6 is monolithically formed in the MMIC voltage controlled oscillator chip 18. This circuit structure ensures a high producibility. In addition, while the drain terminal 2 of the VCO and the drain terminal 11 of the source follower circuit 16 is separately provided in figure 6, they may be connected with each other to be a single terminal.

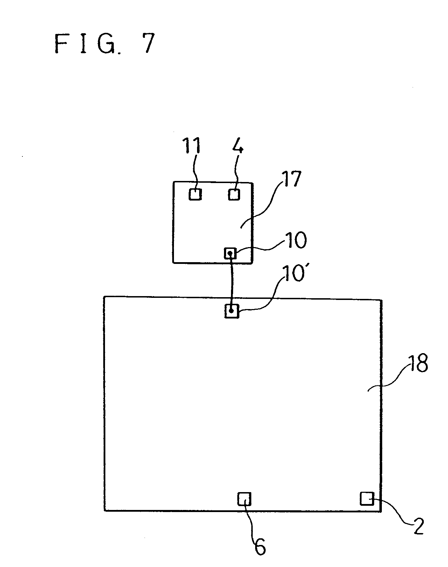

Figure 7 is a plan view showing a variable frequency oscillator in accordance with a fourth embodiment of the present invention. In figure 7, the MMIC source follower circuit chip 17 of figure 5 is provided outside the MMIC voltage controlled oscillator chip 18 and the output terminal 10 of the source follower circuit chip 17 is connected with the VCO control terminal 10' (corresponding to the control terminal 4 of figure 9) of the voltage controlled oscillator chip 18 by wire bonding, ribbon bonding, or the like. This circuit structure can be obtained without reconstructing the whole oscillator.

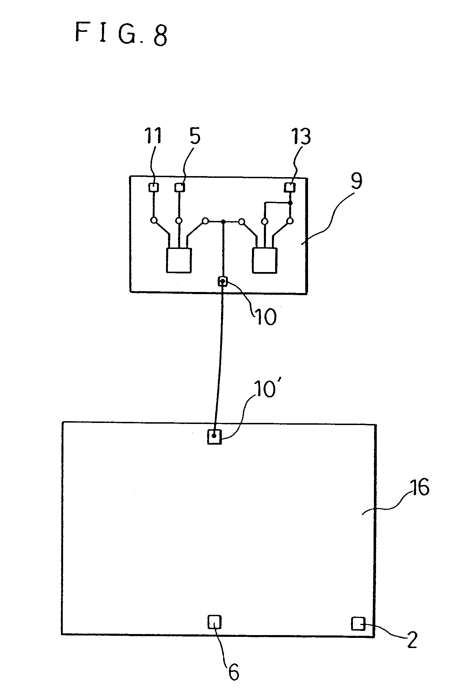

In the above described third and fourth embodiments, the MMIC source follower circuit is monolithically integrated in the MMIC voltage controlled oscillator chip or the MMIC source follower circuit chip is provided separately from the MMIC voltage controlled oscillator chip and these are connected with each other by wire bonding or the like. However, as shown in figure 8, a hybrid IC source follower circuit chip 19 may be provided separately from the MMIC voltage controlled oscillator chip and these are connected with each other by wire bonding or the like. Since this hybrid IC source follower circuit can be easily constituted by only two transistors, it can be easily put into a practical use.

While in the above-described embodiments field effect transistors are used for the VCO, other amplifying elements such as bipolar transistors can be used.

As is evident from the foregoing description, according to the present invention, an impedance conversion means is provided between the voltage controlled oscillator and the controlled voltage power supply thereby to reduce the output impedance of the control voltage power supply. Therefore, a current having high current driving ability is applied to the voltage controlled oscillator, whereby the self-detecting voltage can be suppressed while the oscillation output of the circuit is increased. As a result, a variable frequency oscillator having an improved linearity of oscillation frequency can be obtained.

**Claims**

1. A variable frequency oscillator comprising:
    a voltage controlled oscillator including a variable capacitance diode;
    a control voltage applied to said diode, by which the output frequency of said voltage controlled oscillator is controlled;
    a control voltage power supply generating said control voltage; and
    an impedance conversion means for decreasing the output impedance of said control voltage power supply, provided between said voltage controlled oscillator and said control voltage power supply.

2. A variable frequency oscillator as defined in claim 1 wherein said impedance conversion means is a source follower circuit comprising:
    a first and a second FETs;
    a gate terminal of said first FET serving as an input voltage terminal of the source follower circuit;
    a junction point of a source terminal of said first FET and a drain terminal of said second FET serving as an output voltage terminal of the source follower circuit;
    a source terminal of said second FET being grounded; and
    a drain terminal of said first FET to which a positive voltage is applied.

3. A variable frequency oscillator as defined in claim 2 wherein said gate terminal of said second FET is connected to the source terminal thereof which is grounded.

4. A variable frequency oscillator as defined in claim 2 wherein means for applying a predetermined voltage to the gate terminal of the second FET thereby to prevent the positive voltage applied to the drain terminal of the first FET from flowing into the ground via the second FET.

5. A variable frequency oscillator as defined in claim 1 wherein said impedance conversion means is monolithically formed in a chip constituting said voltage controlled oscillator.

6. A variable frequency oscillator as defined in claim 1 wherein said impedance conversion means is monolithically formed and arranged separately from a chip constituting said voltage controlled oscillator.

7. A variable frequency oscillator as defined in claim 1 wherein said impedance conversion means is formed as a hybrid IC and arranged separately from a chip constituting said voltage controlled oscillator.

8. A variable frequency oscillator as defined in claim 1 wherein said voltage controlled oscillator is a common drain/source type oscillator comprising:
    an FET, a gate of which is connected to the latter stage of said variable capacitance diode, a drain of which is grounded, and a source of which is an oscillation output.

9. A variable frequency oscillator as defined in claim 1 wherein a load circuit connected to the latter stage of said voltage controlled oscillator is a frequency synthesizer.

10. A variable frequency oscillator (fig.1) comprising:
    a voltage controllable oscillator (1) including a variable capacitance diode (D);
    which variable frequency oscillator is characterised by:
    an impedance conversion means (15) connected between said voltage controllable oscillator (1) and an input (4) for applying a control voltage ($V_{cont}$) to said voltage controllable oscillator (1), which impedance conversion means (15) is operable to decrease the effective output impedance of a control voltage power supply (5) which in use is connected to said input (4).

F I G. 1

# F I G. 2

(source follower input voltage)

F I G. 3

# F I G.4

FIG. 5

FIG. 6

F I G. 7

F I G. 8

FIG. 9 (PRIOR ART)

FIG. 10 (PRIOR ART)

# F I G. 11 (PRIOR ART)

TEMPARETURE ( 27.0 [deg] )

oscillation frequency

Fo

Fosc [GHz]

(normal state)

Controll Voltage [V]